# FASCICULE DE BREVET EUROPEEN

(11) **EP 2 898 546 B1**
(45) Date de publication et mention de la délivrance du brevet: **02.08.2017**
(21) Numéro de dépôt: 13789604.9
(22) Date de dépôt: 17.09.2013
(51) Int. Cl.: H01L 33/00, H01L 33/18, H01L 31/0352, H01L 31/18, H01L 21/20, B82Y 40/00, H01L 33/08, H01L 33/24

(54) **DISPOSITIF OPTO-ÉLECTRONIQUE À MICROFILS OU NANOFILS SEMI-CONDUCTEURS ET SON PROCÉDÉ DE FABRICATION**
OPTOELEKTRONISCHES BAUELEMENT BASIEREND AUF HALBLEITERMIKRO- ODER NANO-DRÄHTEN, SOWIE DAZUGEHÖRIGES HERSTELLUNGSVERFAHREN
SEMICONDUCTOR MICROWIRE- OR NANOWIRE-BASED OPTOELECTRONIC DEVICE AND METHOD OF MANUFACTURING THE SAME

(30) Priorité: 18.09.2012 FR 1258729; 12.10.2012 US 201261713108 P
(43) Date de publication de la demande: 29.07.2015
(73) Titulaire: Aledia, 38040 Grenoble Cedex (FR); Commissariat à l'Energie Atomique et aux Energies Alternatives, 75015 Paris (FR)
(72) Inventeur: POUGEOISE, Emilie, F-38000 Grenoble (FR); DUSSAIGNE, Amélie, F-38260 Saint Hilaire de la Cote (FR)
(74) Mandataire: Thibon, Laurent
(86) Numéro de dépôt international: PCT/FR2013/052128
(87) Numéro de publication internationale: WO 2014/044960

(56) Documents cités:
- EP-A1- 2 544 249
- EP-A2- 1 467 404
- US-A1- 2010 133 509
- US-A1- 2012 205 613
- US-B2- 7 829 443
- CHEN X ET AL: "Homoepitaxial growth of catalyst-free GaN wires on N-polar substrates", APPLIED PHYSICS LETTERS, AIP, AMERICAN INSTITUTE OF PHYSICS, MELVILLE, NY, US, vol. 97, no. 15, 13 octobre 2010 (2010-10-13), pages 151909-151909, XP012137241, ISSN: 0003-6951, DOI: 10.1063/1.3497078
- S. F. LI ET AL: "Polarity and Its Influence on Growth Mechanism during MOVPE Growth of GaN Sub-micrometer Rods", CRYSTAL GROWTH & DESIGN, vol. 11, no. 5, 4 mai 2011 (2011-05-04), pages 1573-1577, XP055013312, ISSN: 1528-7483, DOI: 10.1021/cg101537m

## Description

### Domaine de l'invention

La présente invention concerne de façon générale les matériaux semiconducteurs, les dispositifs à base de matériaux semiconducteurs et leurs procédés de fabrication. La présente invention concerne plus particulièrement les microfils ou nanofils semiconducteurs et les dispositifs comprenant des microfils ou nanofils semiconducteurs.

### Exposé de l'art antérieur

Le document EP 1 467 404 A2 décrit un dispositif opto-électrique étendu (un écran émissif) comprenant des structures semiconductrices pyramidales de taille micrométrique, à base de semiconducteurs en nitrures d'éléments du groupe III (typiquement en nitrure de gallium, GaN). Ces structures pyramidales sont formées sur des zones induisant leur croissance suivant la polarité de l'élément N (surface terminée azote); zones réparties dans une seconde zone induisant, elle, la croissance de blocs semiconducteurs nitrures suivant la polarité de l'élément III (surface terminée gallium). Les microfils ou les nanofils comprenant un matériau semiconducteur comportant majoritairement un élément du groupe III et un élément du groupe V (par exemple du nitrure de gallium GaN), appelés par la suite composé III-V, permettent la fabrication de dispositifs semiconducteurs tels que des dispositifs opto-électriques. Par dispositifs opto-électriques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés aux applications photovoltaïques.

Les procédés de fabrication de microfils ou de nanofils comprenant un composé III-V doivent permettre la fabrication des microfils ou des nanofils avec un contrôle précis et uniforme de la géométrie, de la position et des propriétés cristallographiques de chaque microfil ou nanofil. Chen X. J. et al., dans: "Homoepitaxial growth of catalyst-free GaN wires on N-polar substrates", Applied Physics Letters, vol. 97, no. 15, 13 octobre 2010, pages 151909-1 à 151909-3, décrivent et analysent la morphologie de nanofils en nitrure de gallium; nanofils droits ou pyramidaux en fonction de leur polarité, respectivement N ou Ga, induite par la nature du substrat cristallin et/ou par la nature du masque employé pour contrôler la croissance des nanofils. Le document US 7 829 443 B2 décrit un procédé de fabrication de nanofils comprenant le dépôt d'une couche en un matériau diélectrique sur une face plane d'un substrat, la gravure d'ouvertures dans la couche du matériau diélectrique pour exposer des portions du substrat et la formation des nanofils dans les ouvertures. Le matériau diélectrique est choisi de façon que les nanofils ne tendent pas à croître directement sur celui-ci.

Un inconvénient du procédé décrit dans le document US 7 829 443 B2 est que les nanofils se développent depuis le substrat en premier lieu dans les ouvertures de la couche du matériau diélectrique. La forme des parois latérales des ouvertures doit donc être définie avec précision, de préférence perpendiculairement à la face du substrat, pour ne pas perturber la croissance des nanofils. Il peut être difficile de former des parois latérales parfaitement perpendiculaires à une échelle industrielle et à bas coût.

### Résumé

Ainsi, un objet d'un mode de réalisation de la présente invention est de pallier au moins en partie les inconvénients des dispositifs opto-électriques à microfils ou nanofils et de leurs procédés de fabrication décrits précédemment.

Un autre objet d'un mode de réalisation de la présente invention est que les microfils ou nanofils en composé III-V ne sont pas réalisés au travers d'ouvertures réalisées dans une couche d'un matériau diélectrique.

Un autre objet d'un mode de réalisation de la présente invention est que les microfils ou nanofils en composé III-V sont formés sur une surface sensiblement plane.

Un autre objet d'un mode de réalisation de la présente invention est que la position, la géométrie et les propriétés cristallographiques de chaque microfil ou nanofil en composé III-V peuvent être contrôlées de façon précise et uniforme.

Un autre objet d'un mode de réalisation de la présente invention est que les microfils ou nanofils en composé III-V peuvent être formés à une échelle industrielle et à bas coût.

Ainsi, la présente invention prévoit un dispositif opto-électrique comprenant des microfils ou nanofils sur un support, chaque microfil ou nanofil comprenant au moins une portion comprenant majoritairement un composé III-V en contact avec le support, dans lequel le composé III-V est à base d'un premier élément du groupe V et d'un deuxième élément du groupe III, dans lequel une face du support comprend des premières zones d'un premier matériau favorisant la croissance du composé III-V selon la polarité du premier élément réparties dans une deuxième zone d'un deuxième matériau favorisant la croissance du composé selon la polarité du deuxième élément, les microfils ou nanofils étant situés sur les premières zones; dispositif dans lequel le pourtour de ladite portion est recouvert d'une couche d'un matériau diélectrique depuis le support sur une partie de la hauteur totale de ladite portion, dans lequel le matériau diélectrique comprend le premier élément et un troisième élément, différent des premier et deuxième éléments, et dans lequel chaque microfil ou nanofil comprend, en outre, le troisième élément seulement sur ladite partie de la hauteur totale. Selon un mode de réalisation de la présente invention, la couche du matériau diélectrique a une épaisseur comprise entre une monocouche atomique et 5 nm.

Selon un mode de réalisation de la présente invention, le premier matériau comprend du nitrure de magnésium ou du nitrure de magnésium et de gallium.

Selon un mode de réalisation de la présente invention, le deuxième matériau comprend du nitrure d'aluminium.

Selon un mode de réalisation de la présente invention, des blocs sont situés sur la deuxième zone, les blocs comprenant ledit composé et ayant une épaisseur comprise entre 50 nm et 5 µm et strictement inférieure à la hauteur des microfils ou nanofils.

Selon un mode de réalisation de la présente invention, la couche du matériau diélectrique recouvre, en outre, les blocs.

Selon un mode de réalisation de la présente invention, les premières zones sont séparées les unes des autres par la deuxième zone et, pour chaque première zone, un seul microfil ou nanofil est au contact de ladite première zone.

Selon un mode de réalisation de la présente invention, le composé III-V est un composé III-N, notamment choisi parmi le groupe comprenant le nitrure de gallium, le nitrure d'aluminium, le nitrure d'indium, le nitrure de gallium et d'indium, le nitrure de gallium et d'aluminium et le nitrure de gallium, d'aluminium et d'indium.

Selon un mode de réalisation de la présente invention, le matériau diélectrique comprend du nitrure de silicium.

Selon un mode de réalisation de la présente invention, la hauteur totale de ladite portion de chaque microfil ou nanofil est supérieure ou égale à 500 nm.

Un mode de réalisation de la présente invention prévoit, en outre, un procédé de fabrication d'un dispositif opto-électrique tel que décrit précédemment, dans lequel le composé III-V est à base d'un premier élément du groupe V et d'un deuxième élément du groupe III, le procédé comprenant les étapes suivantes :
(i) former, sur un substrat, des premières zones d'un premier matériau favorisant la croissance du composé III-V selon la polarité du premier élément et une deuxième zone d'un deuxième matériau favorisant la croissance du composé selon la polarité du deuxième élément, les premières zones étant entourées par la deuxième zone ; et
(ii) former les microfils ou nanofils sur les premières zones en injectant simultanément dans un réacteur les précurseurs des premier et deuxième éléments, le procédé comprenant, en outre, la formation d'une couche d'un matériau diélectrique recouvrant ladite portion depuis le support sur une partie de la hauteur de ladite portion, le matériau diélectrique comprenant le premier élément et, en outre, un troisième élément différent des premier et deuxième éléments, le procédé comprenant, à l'étape (ii), l'injection simultanée dans le réacteur des précurseurs des premier, deuxième et troisième éléments.

Selon un mode de réalisation de la présente invention, l'étape (ii) est suivie d'une étape de croissance des microfils ou nanofils en injectant dans le réacteur les précurseurs des premier et deuxième éléments, sans injecter le précurseur du troisième élément.

Selon un mode de réalisation de la présente invention, le procédé comprend, en outre, à l'étape (ii), la formation de blocs sur la deuxième zone, les blocs comprenant ledit composé et ayant une épaisseur comprise entre 50 nm et 5 µm et strictement inférieure à la hauteur des microfils ou nanofils.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est une coupe, partielle et schématique, d'un mode de réalisation selon l'invention d'un dispositif opto-électrique à microfils ou nanofils ;
les figures 2A à 2H sont des coupes, partielles et schématiques, des structures obtenues à des étapes successives d'un mode de réalisation selon l'invention d'un procédé de fabrication du dispositif opto-électrique représenté en figure 1 ;
les figures 3A à 3F sont des coupes, partielles et schématiques, des structures obtenues à des étapes successives d'un autre mode de réalisation selon l'invention d'un procédé de fabrication d'une variante du dispositif opto-électrique représenté en figure 1 ; et
la figure 4 est une coupe, partielle et schématique, d'un autre mode de réalisation selon l'invention d'un dispositif opto-électrique à microfils ou nanofils.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de l'invention ont été représentés et seront décrits. En particulier, les moyens de commande des dispositifs opto-électriques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente invention concerne la fabrication de microfils ou de nanofils. Le terme "microfil" ou "nanofil" signifie une structure tridimensionnelle de forme allongée dont au moins deux dimensions, appelées dimensions mineures, sont comprises entre 5 nm et 2,5 µm, la troisième dimension, appelée dimension majeure, étant au moins égale à 1 fois la plus grande des dimensions mineures, de préférence au moins 5 fois et encore plus préférentiellement au moins 10 fois. Dans certains modes de réalisation, les dimensions mineures peuvent être inférieures ou égales à environ 1000 nm, de préférence comprises entre 100 nm et 300 nm. Dans certains modes de réalisation, la hauteur de chaque microfil ou nanofil peut être supérieure ou égale à 500 nm, de préférence comprise entre 1 µm et 50 µm.

La section droite des microfils ou nanofils peut avoir différentes formes, telles que, par exemple, une forme ovale, circulaire ou polygonale, notamment triangulaire, rectangulaire, carrée ou hexagonale. De même, les microfils ou nanofils peuvent avoir une forme tridimensionnelle cylindrique, conique et/ou tronconique.

Les microfils ou nanofils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également êtres utilisés, par exemple, le phosphore ou l'arsenic. De façon générale, les éléments dans le composé III-V peuvent être combinés avec différentes fractions molaires.

Dans certains modes de réalisation, les microfils ou nanofils peuvent comprendre un dopant parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV comprenant le silicium (Si), le germanium (Ge), le sélénium (Se), le soufre (S), le terbium (Tb) et l'étain (Sn).

Les microfils ou nanofils sont formés sur une face d'un substrat. Le substrat est, par exemple, un substrat semiconducteur, tel qu'un substrat en silicium, en germanium, en carbure de silicium, en un matériau composé d'un élément du groupe III et d'un élément du groupe V, tel que du GaN ou du GaAs, un substrat en ZnO, en saphir, en métal, en céramique ou en verre.

Le principe de l'invention est de former sur le substrat, sur lequel on souhaite faire croître les microfils ou nanofils, une surface de fixation de polarité obtenue par des zones d'un premier matériau entourées d'une zone d'un deuxième matériau. Selon un mode de réalisation de l'invention, cette surface peut être sensiblement plane.

Le premier matériau est choisi de façon à favoriser la croissance du composé III-V selon la polarité de l'élément du groupe V. Le deuxième matériau est choisi de façon à favoriser la croissance du composé III-V selon la polarité de l'élément du groupe III. Dans certains modes de réalisation de l'invention, le substrat peut correspondre au premier matériau ou au second matériau.

Le fait de dire qu'un composé III-V croît selon la polarité de l'élément du groupe III ou selon la polarité de l'élément du groupe V signifie que le matériau croît selon une direction privilégiée et que lorsque le matériau est coupé dans un plan perpendiculaire à la direction de croissance privilégiée, la face exposée comprend essentiellement des atomes de l'élément du groupe III dans le cas d'une croissance selon la polarité de l'élément du groupe III ou des atomes de l'élément du groupe V dans le cas d'une croissance selon la polarité de l'élément du groupe V.

Dans le cas où l'élément du groupe V est l'azote, le premier matériau peut être principalement composé de nitrure de magnésium sous la forme MgₓN_{y}, par exemple de nitrure de magnésium selon la forme Mg₃N₂ ou du nitrure de gallium et de magnésium (MgGaN). Selon un autre exemple, le premier matériau est principalement composé de nitrure d'aluminium (AlN) de polarité azote. Il s'agit, par exemple, de nitrure d'aluminium monocristallin formé à basse température, par exemple à une température comprise entre 600°C et 800°C, par épitaxie sur un substrat en saphir.

A titre d'exemple, dans le cas où l'élément du groupe III est le gallium, le deuxième matériau peut être principalement composé de nitrure d'aluminium (AlN) de polarité aluminium. Il s'agit, par exemple, de nitrure d'aluminium monocristallin formé par épitaxie sur un substrat en silicium déposé sous forme monocristalline. Selon un autre exemple, dans le cas où l'élément du groupe III est le gallium, le deuxième matériau peut être principalement composé de nitrure de gallium de polarité gallium. Il s'agit, par exemple, de nitrure de gallium formé à basse température, par exemple à une température comprise entre 500°C et 800°C, sur un substrat en saphir. Selon un autre exemple, dans le cas où le substrat est du saphir nitruré et l'élément du groupe III est le gallium, le substrat peut jouer le rôle du deuxième matériau.

Le procédé de croissance des microfils ou nanofils peut être un procédé du type dépôt chimique en phase vapeur organométallique (MOCVD, acronyme anglais pour Metal-Organic Chemical Vapor Deposition), également connu sous le nom d'épitaxie organométallique en phase vapeur (ou OMVPE, acronyme anglais pour Organo-Metallic Vapor Phase Epitaxy). Toutefois, des procédés tels que l'épitaxie par jet moléculaire (MBE, acronyme anglais pour Molecular-Beam Epitaxy), la MBE à source de gaz (GSMBE), MBE organométallique (MOMBE), l'épitaxie par couche atomique (ALE, acronyme anglais pour Atomic Layer Epitaxy) ou l'épitaxie en phase vapeur à base d'hydrures (HVPE, acronyme anglais pour Hydride Vapor Phase Epitaxy) peuvent être utilisés.

A titre d'exemple, le procédé peut comprendre l'injection dans un réacteur d'un précurseur de l'élément du groupe III et d'un précurseur de l'élément du groupe V. Des exemples de précurseurs d'éléments du groupe III sont le triméthylgallium (TMG), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP) ou l'arsine (AsH₃).

Dans le cas de microfils ou nanofils d'un composé III-V, le composé III-V croît selon la polarité de l'élément du groupe V sur les zones du premier matériau et selon la polarité de l'élément du groupe III sur la zone du deuxième matériau.

Selon un mode de réalisation de l'invention, dans une première phase de croissance des microfils ou nanofils du composé III-V, un précurseur d'un élément supplémentaire est ajouté en excès par rapport aux précurseurs du composé III-V. L'élément supplémentaire peut être le silicium (Si). Un exemple de précurseur du silicium est le silane (SiH₄).

La présente invention se base sur le fait que l'angle que forment, par rapport à la face du substrat, les flancs latéraux d'un cristal d'un composé III-V qui croît sur le substrat selon la polarité de l'élément du groupe V est supérieur à l'angle que forment, par rapport à la face du substrat, les flancs latéraux d'un cristal du composé III-V qui croît sur un substrat selon la polarité de l'élément du groupe III. En particulier, l'angle que forment, par rapport à la face du substrat, les flancs latéraux d'un cristal d'un composé III-V qui croît sur le substrat selon la polarité de l'élément du groupe V est supérieur à 85°, et est de préférence sensiblement égal à 90°. En particulier, l'angle que forment, par rapport à la face du substrat, les flancs latéraux d'un cristal d'un composé III-V qui croît sur le substrat selon la polarité de l'élément du groupe III est inférieur à 80°, de préférence inférieur à 70°.

Les inventeurs ont mis en évidence que la présence du précurseur de l'élément supplémentaire conduit à l'incorporation de l'élément supplémentaire dans le composé III-V mais également la formation d'une couche d'un matériau diélectrique principalement constitué de l'élément supplémentaire et de l'élément du groupe V sur les flancs latéraux des cristaux en croissance du composé III-V. La concentration de l'élément supplémentaire dans le composé III-V est comprise entre 10¹⁸ et 10²¹ cm⁻³. La couche du matériau diélectrique a une épaisseur comprise entre une monocouche atomique et 5 nm.

Pour le cristal qui croît selon la polarité de l'élément du groupe III, la couche du matériau diélectrique qui se forme sur les flancs inclinés empêche une croissance ultérieure du composé III-V une fois que les flancs inclinés se sont rejoints au sommet. Les structures ou blocs obtenus dudit composé sur la zone du deuxième matériau ont une épaisseur comprise entre 50 nm et 5 µm, de préférence entre 500 nm et 4 µm. Cette épaisseur dépend de la distance centre à centre entre deux microfils ou nanofils. La hauteur des microfils ou nanofils est de préférence strictement supérieure à l'épaisseur des blocs.

Au contraire, pour le cristal qui croît selon la polarité de l'élément du groupe V, la couche du matériau diélectrique qui se forme sur les flancs sensiblement perpendiculaires à la face du substrat n'empêche pas la poursuite de la croissance du cristal du composé III-V en hauteur. De ce fait, on obtient la croissance de microfils ou de nanofils du composé III-V seulement sur les zones du premier matériau.

De façon avantageuse, les structures ou blocs obtenus entre les microfils ou nanofils permettent l'obtention d'une surface irrégulière, non plane, entre les microfils ou nanofils. Lorsque cette surface est recouverte d'un matériau réfléchissant, ceci permet de mieux diriger les rayons lumineux vers les microfils ou nanofils ou provenant des microfils ou nanofils. Des exemples de matériaux réfléchissants peuvent être le nickel, l'aluminium et l'argent.

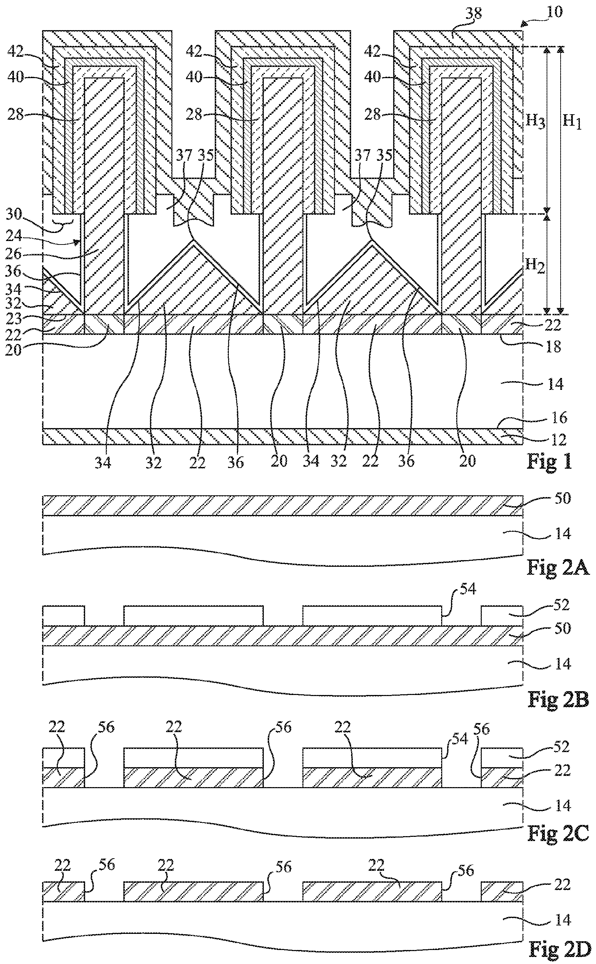

La figure 1 est une coupe, partielle et schématique, d'un mode de réalisation selon l'invention d'un dispositif opto-électrique 10 qui est adapté pour émettre un rayonnement électromagnétique.

Le dispositif 10 comprend, du bas vers le haut en figure 1 :
une première électrode de polarisation 12 ;
un substrat semiconducteur 14 comprenant des faces parallèles 16 et 18, la face 16 étant au contact de l'électrode 12 ;
des zones 20 de fixation de polarité du premier matériau séparées par des zones 22 de fixation de polarité du deuxième matériau recouvrant la face 18, les zones 20 et 22 étant juxtaposées et définissant une face 23 opposée à la face 18 ;
des microfils ou nanofils 24 (trois microfils ou nanofils étant représentés) de hauteur H₁, chaque microfil ou nanofil 24 étant en contact avec l'une des zones 20, chaque microfil ou nanofil 24 comprenant une portion de contact 26, en contact avec la zone 20, une portion active 28 en contact avec la portion de contact 26 et une portion de polarisation 30 en contact avec la portion active 28 ;
des structures ou blocs 32, au contact des zones 22, comprenant des flancs inclinés 34 se rejoignant selon des arêtes 35 ;
une couche diélectrique 36 recouvrant les flancs inclinés 34 des structures 32 et une partie du pourtour de la portion de contact 26 de chaque microfil ou nanofil 24 à partir de la base du microfil ou nanofil 24 en contact avec la zone 20 associée ;
une couche isolante 37 recouvrant les blocs 32 et, pour chaque microfil ou nanofil 24, une partie du microfil ou nanofil 24 à partir de la base du microfil ou nanofil 24 en contact avec la zone 20 jusqu'à venir couvrir le bord de la portion de polarisation 30 ; et
une deuxième électrode 38 de polarisation en contact avec chaque microfil ou nanofil 24 au niveau de la portion de polarisation 30.

Le substrat 14 est, par exemple, un substrat semiconducteur, tel qu'un substrat en silicium. Le substrat 14 peut être dopé d'un premier type de conductivité.

L'électrode 12 peut correspondre à une couche conductrice qui s'étend sur la face 16 du substrat 14. Le matériau formant l'électrode 12 peut être, par exemple, du siliciure de nickel (NiSi), de l'aluminium (Al) ou du titane (Ti).

Les zones 22 de fixation de polarité sont de préférence reliées les unes aux autres et forment une zone continue unique. Les zones 20 de fixation de polarité sont de préférence séparées les unes des autres par la zone 22. Chaque zone 20 est complètement entourée par la zone 22. Les zones 20, 22 ont, par exemple, une épaisseur comprise entre 1 et 100 nm, de préférence comprise entre 10 et 30 nm. Chaque zone 20, 22 a une texturation et une polarité préférentielle. Par texturation préférentielle, on entend que les cristaux qui composent les zones 20 (respectivement les zones 22) ont une direction de croissance privilégiée qui est la même pour toutes les zones 20 (respectivement les zones 22). Par polarité préférentielle, on entend que les zones 20 (respectivement les zones 22) ont sensiblement toutes la même polarité. Ceci signifie que lorsque le matériau composant chaque zone 20 (respectivement chaque zone 22) comprend un alliage d'au moins deux éléments, lorsque le matériau est coupé dans un plan perpendiculaire à la direction de croissance privilégiée du matériau, la surface exposée comprend essentiellement des atomes du même élément pour chaque zone 20 (respectivement pour chaque zone 22).

Chaque zone 20 peut présenter le même type de conductivité que le substrat 14 afin de limiter la résistance d'interface entre la zone 20, 22 et le substrat 14. Chaque zone 20 présente une forme correspondant à la section droite souhaitée pour le microfil ou nanofil 24 associé. A titre d'exemple, chaque zone 20 a une forme sensiblement hexagonale dont le diamètre moyen est choisi en fonction du diamètre moyen recherché du microfil ou nanofil 24 associé. A titre de variante, chaque zone 20 peut avoir une forme rectangulaire, polygonale, circulaire, carrée ou ovale.

Les centres de deux zones 20 adjacentes peuvent être distants de 1,5 µm à 5 µm et de préférence de 2 à 3 µm. A titre d'exemple, les zones 20 peuvent être régulièrement réparties sur le substrat 14, la zone 22 formant un quadrillage entourant chaque zone 20. A titre d'exemple, les zones 20 peuvent former un réseau hexagonal sur la zone 22.

L'épaisseur de chaque structure 32 mesurée depuis la zone 22 sous-jacente est de préférence inférieure ou égale à 5 µm, par exemple comprise entre 500 nm et 4 µm. L'angle d'inclinaison entre la face 34 et la face 23 est, par exemple, inférieur à 80°, de préférence inférieure à 70°, en particulier sensiblement égale à 60°.

Chaque microfil ou nanofil 24 est une structure semiconductrice allongée dans la direction sensiblement perpendiculaire à la face 18. Chaque microfil ou nanofil 24 peut avoir une forme générale cylindrique allongée à base hexagonale. Le diamètre moyen de chaque microfil ou nanofil 24 peut être compris entre 50 nm et 2,5 µm et la hauteur H₁ de chaque microfil ou nanofil 24 peut être comprise entre 1 µm et 50 µm.

La portion de contact 26 de chaque nanofil ou microfil 24 est principalement constituée du composé III-N qui peut avoir le même type de conductivité que le substrat 14. Le pourtour de la portion de contact 26 est recouvert par la couche 36 de diélectrique sur une hauteur H₂ depuis l'extrémité de la portion de contact 26 au contact avec la zone 20 associée. La hauteur H₂ peut être comprise entre 500 nm et 25 µm. La couche de matériau diélectrique 36 a une épaisseur comprise entre une monocouche atomique et 5 nm.

Pour chaque microfil ou nanofil 24, la portion active 28 correspond à une couche recouvrant l'extrémité de la portion de contact 26 et se prolongeant sur la fraction de la portion de contact 26 non recouverte par la couche 36 du côté opposé à la zone 20 de fixation de polarité.

La portion active 28 est au moins partiellement réalisée dans un composé III-N, par exemple du nitrure de gallium et d'indium. La portion active 28 peut être dopée du premier type de conductivité, ne pas être dopée ou être dopée d'un deuxième type de conductivité opposé au premier type de conductivité. Chaque portion active 28 forme une jonction semiconductrice avec la portion de contact 26 correspondante. La portion active 28 peut comporter des moyens de confinement, tels que des puits quantiques multiples.

Pour chaque microfil ou nanofil 24, la portion de polarisation 30 peut comprendre un matériau III-N. La portion de polarisation 30 peut avoir une conductivité du deuxième type. La portion de polarisation 30 peut comprendre une couche de blocage d'électrons 40, comportant un dopage du deuxième type de conductivité, en nitrure de gallium et d'aluminium (AlGaN), en contact avec la portion active 28 et une couche supplémentaire 42, pour assurer un bon contact électrique entre la deuxième électrode 38 et la portion active 28, par exemple en nitrure de gallium (GaN) en contact avec la couche de blocage d'électrons 40 et avec l'électrode 38. L'ensemble du microfil ou nanofil 24 comprenant la fraction de la portion de contact 26 non recouverte de la couche 36, la portion active 28 et la portion de polarisation 30, s'étend sur une hauteur H₃ qui peut être comprise entre 500 nm et 25 µm.

La couche isolante 37 est adaptée pour empêcher la formation d'un contact électrique direct entre la portion de contact 26 de chaque microfil ou nanofil 24 et l'électrode 38. La couche isolante 37 peut être en un matériau diélectrique, par exemple en oxyde de silicium (SiO₂), en nitrure de silicium (Si₃N₄), en oxyde d'aluminium (Al₂O₃), en oxyde d'hafnium (HfO₂) ou en diamant.

La deuxième électrode 38 est adaptée pour à la fois polariser la portion de polarisation 30 de chaque microfil ou nanofil 24 et laisser passer le rayonnement électromagnétique émis par les microfils ou nanofils 24. Le matériau formant l'électrode 38 peut être un matériau semi-transparent tel que de l'oxyde d'indium-étain (ou ITO, acronyme anglais pour Indium Tin Oxide) ou de l'oxyde de zinc dopé à l'aluminium.

Les figures 2A à 2H illustrent les structures obtenues à des étapes successives d'un mode de réalisation d'un procédé de fabrication du dispositif opto-électrique 10 de la figure 1.

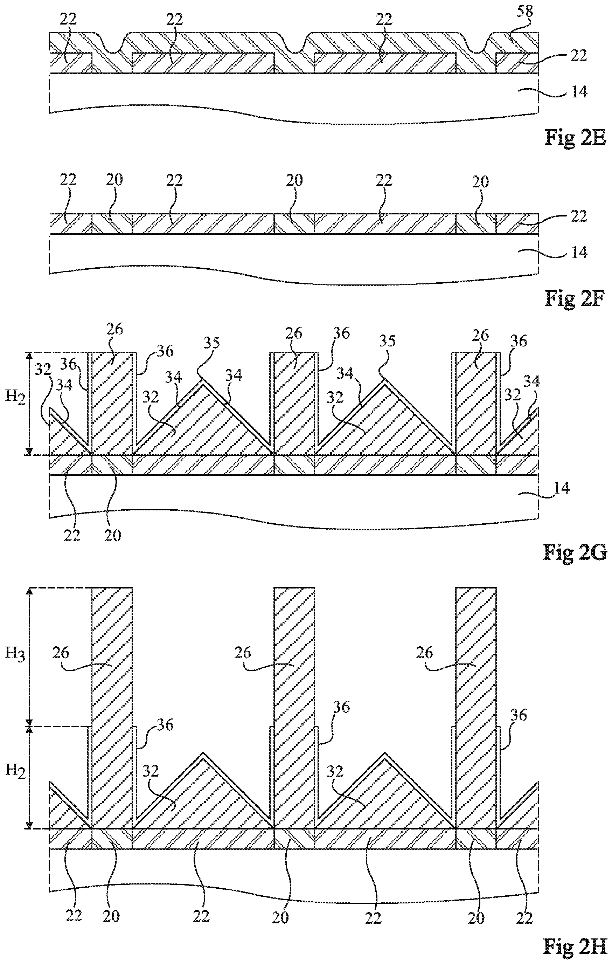

Le mode de réalisation du procédé de fabrication selon l'invention comprend les étapes suivantes :
(1) Dépôt sur le substrat 14 d'une couche 50 uniforme du second matériau favorisant la croissance du composé III-N selon une polarité de l'élément du groupe III (figure 2A). Il s'agit à titre d'exemple de nitrure d'aluminium. La couche 50 a par exemple une épaisseur comprise entre 1 nm et 2 µm, de préférence entre 1 et 100 nm. La couche 50 peut être obtenue par un procédé du type MOCVD. Toutefois, des procédés tels que CVD, MBE, GSMBE, MOMBE, ALE, HVPE ou la pulvérisation cathodique réactive peuvent être utilisés ou tout type de dépôt permettant l'obtention d'une couche texturée. Lorsque la couche 50 est en nitrure d'aluminium, la couche 50 doit être sensiblement texturée et posséder une polarité préférentielle.
(2) Dépôt d'une couche de résine 52 sur la couche 50 et gravure d'ouvertures 54 dans la couche de résine 52 pour exposer des parties de la couche 50 (figure 2B).
(3) Gravure d'ouvertures 56 dans la couche 50 pour former la zone 22 (figure 2C). Les ouvertures 56 ont sensiblement la forme de la section souhaitée pour les microfils ou nanofils 24 à réaliser. La gravure des ouvertures 56 peut être réalisée par gravure sèche, par exemple une gravure ionique réactive ou RIE (sigle anglais pour Reactive Ion Etching) ou une gravure au plasma couplé par induction ou gravure ICP (sigle anglais pour Inductively Coupled Plasma).
(4) Retrait de la couche de résine 52 (figure 2D).
(5) Dépôt d'une couche 58 du premier matériau fournissant la croissance du composé III-N selon la polarité N (figure 2E) sur l'ensemble de la structure obtenue à l'étape précédente et notamment sur les portions 22 et dans les ouvertures 56. Il s'agit, à titre d'exemple, de nitrure de magnésium ou de nitrure de gallium et de magnésium. Le dépôt peut être obtenu par un procédé du type MOCVD. Toutefois, des procédés tels que CVD, MBE, GSMBE, MOMBE, ALE, HVPE ou la pulvérisation cathodique réactive peuvent être utilisés.
(6) Gravure de la couche 58 jusqu'à atteindre les portions 22 et délimiter les zones 20 du premier matériau fournissant la croissance du composé III-N selon la polarité N (figure 2F) dans les ouvertures 56 de la zone 22. Il peut s'agir d'une gravure par polissage mécano-chimique ou CMP (sigle anglais pour Chemical Mechanical Planarization). L'épaisseur des zones 20 est, par exemple, comprise entre 1 nm et 2 µm, de préférence entre 1 et 100 nm.
(7) Croissance d'une fraction de la portion de contact 26 de chaque microfil ou nanofil 24 (figure 2G) sur la hauteur H₂. La fraction de la portion de contact 26 de chaque microfil ou nanofil 24 peut être obtenue par un procédé du type MOCVD. Toutefois, des procédés tels que MBE, GSMBE, MOMBE, ALE ou HVPE peuvent être utilisés.

A titre d'exemple, dans le cas où la portion de contact 26 est en GaN, un procédé du type MOCVD peut être mis en oeuvre par injection dans un réacteur MOCVD d'un gaz précurseur du gallium, par exemple le triméthylgallium (TMG) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la gamme 5-100, de préférence dans la gamme 10-50, permet de favoriser la croissance de microfils et nanofils. A titre d'exemple, les flux de gaz peuvent être d'environ 60 sccm (centimètres cubes standard par minute) en TMG et 50 sccm en NH₃ et l'on utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 100 ppm et l'on apporte un flux molaire d'environ 400 ml par minute. La température dans le réacteur est, par exemple, comprise 950°C et 1100°C, de préférence entre 990°C et 1100°C, plus préférentiellement entre 1015°C et 1060°C. La pression dans le réacteur est, par exemple, d'environ 800 mbar (800 hPa). Un gaz porteur peut être utilisé, par exemple de l'azote, par exemple avec un flux de 1000 sccm pour le TMG et un flux de 1000 sccm pour le NH₃.

Le procédé entraîne également la croissance des structures 32 à flancs inclinés 34 sur la zone 22.

La présence de silane parmi les gaz précurseurs entraîne l'incorporation de silicium au sein du composé III-N. En outre, ceci se traduit par la formation de la couche 36 de nitrure de silicium qui recouvre le pourtour de la portion de contact 26 de hauteur H₂ de chaque nanofil 24, à l'exception du sommet au fur et à mesure de la croissance de la portion de contact 26 et qui recouvre les flancs inclinés 34 de chaque structure 32 au fur et à mesure de la croissance des structures 32. De ce fait, lorsque les flancs inclinés 34 se rejoignent selon l'arête 35 au sommet de la structure 32, la croissance de chaque structure 32 est stoppée.

Les inventeurs ont mis en évidence qu'en l'absence de formation de la couche diélectrique 36, la croissance de la structure 32 n'est pas stoppée et l'épaisseur, mesurée depuis la zone 22, de la structure 32 croît tant que des gaz précurseurs alimentent le réacteur. En outre, le diamètre moyen des microfils ou nanofils 24 tend également à croître au-delà du diamètre moyen des zones 20.

(8) Croissance de la fraction restante de la portion de contact 26 de chaque microfil ou nanofil 24 sur la hauteur H₃ (figure 2H). A titre d'exemple, les conditions de fonctionnement du réacteur MOCVD décrites précédemment sont maintenues à l'exception du fait que le flux de silane dans le réacteur est réduit, par exemple d'un facteur 10, ou arrêté.

Le procédé comprend des étapes supplémentaires de réalisation, pour chaque microfil ou nanofil 24 de la portion active 28, de la portion de polarisation 30, de la couche isolante 37 et des électrodes 12, 38. Ces étapes sont bien connues de l'homme du métier et ne sont pas décrites en détail.

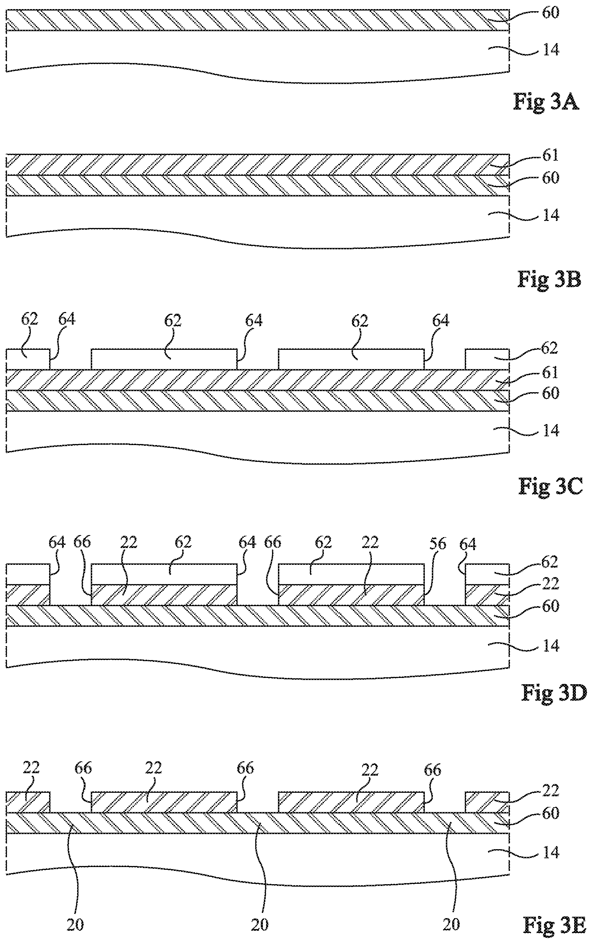

Les figures 3A à 3F illustrent les structures obtenues à des étapes successives d'un mode de réalisation d'un procédé de fabrication d'une variante du dispositif opto-électrique 10 de la figure 1.

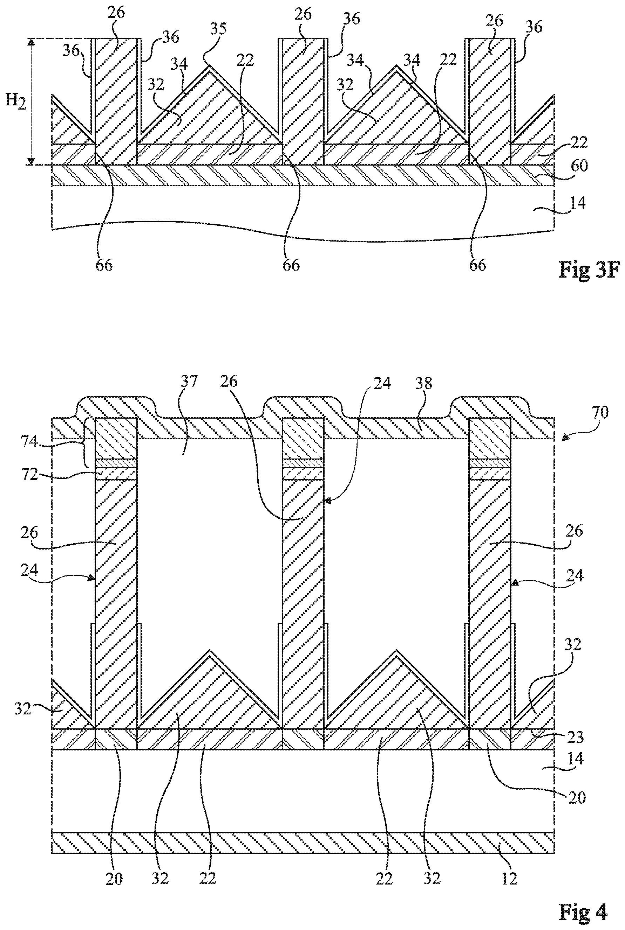

Le mode de réalisation du procédé de fabrication selon l'invention comprend les étapes suivantes :
(1) Dépôt sur le substrat 14 de la couche 60 du premier matériau favorisant la croissance du composé III-N selon une polarité de l'élément N (figure 3A). Il s'agit, à titre d'exemple, de nitrure de magnésium ou de nitrure de gallium et de magnésium. Le dépôt peut être obtenu par un procédé du type MOCVD. Toutefois, des procédés tels que CVD, MBE, GSMBE, MOMBE, ALE, HVPE ou la pulvérisation cathodique réactive peuvent être utilisés.
(2) Dépôt d'une couche 61 du deuxième matériau fournissant la croissance du composé III-N selon la polarité III (figure 3B) sur la couche 60.
(3) Dépôt d'une couche de résine 62 sur la couche 61 et gravure d'ouvertures 64 dans la couche de résine 62 pour exposer des parties de la couche 61 (figure 3C).
(4) Gravure d'ouvertures 66 dans la couche 61 pour former la zone 22 (figure 3D) et délimiter les zones 20 dans la couche 60. Les ouvertures 66 ont sensiblement la forme de la section souhaitée pour les microfils ou nanofils 24 à réaliser. La gravure des ouvertures 66 peut être réalisée par gravure sèche, par exemple une gravure ionique réactive ou RIE (sigle anglais pour Reactive Ion Etching) ou une gravure au plasma couplé par induction ou gravure ICP (sigle anglais pour Inductively Coupled Plasma).
(5) Retrait de la couche de résine 62 (figure 3E).
(6) Croissance d'une fraction de la portion de contact 26 de chaque microfil ou nanofil 24 (figure 3F) sur la hauteur H₂. Chaque microfil ou nanofil 24 est au contact de la couche 60 au travers de l'une des ouvertures 66.

La fraction de la portion de contact 26 de chaque microfil ou nanofil 24 peut être obtenue comme cela a été décrit précédemment en relation avec la figure 2G.

Les étapes suivantes peuvent être identiques à ce qui a été décrit précédemment, notamment en relation avec la figure 2H. Dans le mode de réalisation du procédé de fabrication décrit en relation avec les figures 3A à 3E, les microfils ou nanofils croissent d'abord depuis la couche 60 au travers des ouvertures 66 formées dans la couche 61. Toutefois, la couche 61 étant en un matériau qui n'empêche pas la croissance du composé III-V, la forme des parois latérales des ouvertures 66 peut être définie avec moins de précision que pour un procédé classique dans lequel les microfils ou nanofils sont formés au travers d'ouvertures d'un matériau diélectrique.

La figure 4 est une coupe, partielle et schématique, d'un autre mode de réalisation selon l'invention d'un dispositif opto-électrique 70 qui est adapté pour émettre un rayonnement électromagnétique. Le dispositif 70 diffère du dispositif 10 par la forme de la portion active et de la portion de polarisation de chaque microfil ou nanofil 24. En effet, pour chaque microfil ou nanofil 24, la portion active 72 recouvre seulement le sommet du microfil ou nanofil 24. La portion active 72 peut avoir la même composition que la portion active 28 décrite précédemment. En outre, la portion de polarisation 74 recouvre la portion active 72. La portion de polarisation 74 peut avoir la même composition que la portion de polarisation 30 décrite précédemment.

Des modes de réalisation particuliers de la présente invention ont été décrits. Diverses variantes et modifications apparaîtront à l'homme de l'art. En particulier, bien que dans le mode de réalisation du procédé de fabrication décrit précédemment en relation avec les figures 2A à 2J, la zone 22 soit formée avant les zones 20, il est clair que les zones 20 peuvent être formées avant la zone 22. En outre, si les différents modes de réalisation de dispositifs opto-électriques 10 et 70 décrits précédemment sont adaptés pour émettre un rayonnement électromagnétique, de tels dispositifs peuvent aisément être adaptés par un homme du métier pour recevoir un rayonnement électromagnétique et le convertir en un signal électrique. Une telle adaptation est réalisée en adaptant à la fois la portion active 28, 72 de chacun des microfils ou nanofils 24 et en appliquant sur la structure semiconductrice une polarisation adéquate.

Une telle adaptation du dispositif 10, 70 peut être réalisée pour former soit un dispositif opto-électrique dédié à la mesure ou la détection d'un rayonnement électromagnétique ou soit un dispositif opto-électrique dédié aux applications photovoltaïques.

En outre, bien les modes de réalisation décrits précédemment concernent des composés III-V, la présente invention peut également être mise en oeuvre pour la fabrication de composés II-VI (par exemple l'oxyde de zinc ZnO) comprenant un matériau semiconducteur comportant majoritairement un élément du groupe II et un élément du groupe VI.

L'étendue de la protection conférée est déterminée par les revendications qui suivent; la description et les dessins servant eux à interpréter les revendications.

## Revendications

1. Dispositif opto-électrique (10 ; 70) comprenant des microfils ou nanofils (24) sur un support (14, 20, 22), chaque microfil ou nanofil comprenant au moins une portion (26) comprenant majoritairement un composé III-V en contact avec le support, dans lequel le composé III-V est à base d'un premier élément du groupe V et d'un deuxième élément du groupe III, dans lequel une face (23) du support (14, 20, 22) comprend des premières zones (20) d'un premier matériau favorisant la croissance du composé III-V selon la polarité du premier élément réparties dans une deuxième zone (22) d'un deuxième matériau favorisant la croissance du composé selon la polarité du deuxième élément, les microfils ou nanofils (24) étant situés sur les premières zones, **caractérisé en ce que** le pourtour de ladite portion (26) est recouvert d'une couche (36) d'un matériau diélectrique depuis le support sur une partie de la hauteur totale de ladite portion, **en ce que** le matériau diélectrique comprend le premier élément et un troisième élément, différent des premier et deuxième éléments, et **en ce que** chaque microfil ou nanofil (24) comprend, en outre, le troisième élément seulement sur ladite partie de la hauteur totale.

2. Dispositif opto-électrique selon la revendication 1, dans lequel la couche (36) du matériau diélectrique a une épaisseur comprise entre une monocouche atomique et 5 nm.

3. Dispositif selon la revendication 1 ou 2, dans lequel le premier matériau comprend du nitrure de magnésium ou du nitrure de magnésium et de gallium.

4. Dispositif selon l'une quelconque des revendications 1 à 3, dans lequel le deuxième matériau comprend du nitrure d'aluminium.

5. Dispositif selon l'une quelconque des revendications 1 à 4, dans lequel des blocs (32) sont situés sur la deuxième zone, les blocs comprenant ledit composé et ayant une épaisseur comprise entre 50 nm et 5 µm et strictement inférieure à la hauteur des microfils ou nanofils (24).

6. Dispositif selon la revendication 5, dans lequel la couche (36) du matériau diélectrique recouvre, en outre, les blocs (32).

7. Dispositif selon l'une quelconque des revendications 1 à 6, dans lequel les premières zones (20) sont séparées les unes des autres par la deuxième zone (22) et dans lequel, pour chaque première zone, un seul microfil ou nanofil (24) est au contact de ladite première zone.

8. Dispositif selon l'une quelconque des revendications 1 à 7, dans lequel le composé III-V est un composé III-N, notamment choisi parmi le groupe comprenant le nitrure de gallium, le nitrure d'aluminium, le nitrure d'indium, le nitrure de gallium et d'indium, le nitrure de gallium et d'aluminium et le nitrure de gallium, d'aluminium et d'indium.

9. Dispositif selon l'une quelconque des revendications 1 à 8, dans lequel le matériau diélectrique comprend du nitrure de silicium.

10. Dispositif opto-électrique selon l'une quelconque des revendications 1 à 9, dans lequel la hauteur totale de ladite portion (26) de chaque microfil ou nanofil (24) est supérieure ou égale à 500 nm.

11. Procédé de fabrication d'un dispositif opto-électrique (10 ; 70) selon l'une quelconque des revendications 1 à 10, le procédé comprenant les étapes suivantes :
(i) former, sur le support (14), les premières zones (20) du premier matériau favorisant la croissance du composé III-V selon la polarité du premier élément et la deuxième zone (22) du deuxième matériau favorisant la croissance du composé selon la polarité du deuxième élément, les premières zones étant entourées par la deuxième zone ; et
(ii) former les microfils ou nanofils (24) sur les premières zones en injectant simultanément dans un réacteur les précurseurs des premier et deuxième éléments,
le procédé comprenant, en outre, la formation d'une couche (36) d'un matériau diélectrique recouvrant ladite portion (26) depuis le support (14, 20, 22) sur une partie de la hauteur de ladite portion, le matériau diélectrique comprenant le premier élément et, en outre, un troisième élément différent des premier et deuxième éléments, le procédé comprenant, à l'étape (ii), l'injection simultanée dans le réacteur des précurseurs des premier, deuxième et troisième éléments.

12. Procédé selon la revendication 11, dans lequel l'étape (ii) est suivie d'une étape de croissance des microfils ou nanofils (24) en injectant dans le réacteur les précurseurs des premier et deuxième éléments, sans injecter le précurseur du troisième élément.

13. Procédé selon la revendication 11 ou 12, comprenant en outre, à l'étape (ii), la formation de blocs (32) sur la deuxième zone, les blocs comprenant ledit composé et ayant une épaisseur comprise entre 50 nm et 5 µm et strictement inférieure à la hauteur des microfils ou nanofils (24).

## Patentansprüche

1. Eine optoelektrische Vorrichtung (10; 70), die Folgendes aufweist:
Mikroleitungen oder Nanoleitungen (24) auf einem Träger (14, 20, 22), wobei jede Mikroleitung oder Nanoleitung wenigstens einen Teil (26) aufweist, der hauptsächlich eine III-V-Verbindung in Kontakt mit dem Träger enthält, wobei die III-V Verbindung auf einem ersten Guppe-V-Element und einem zweiten Gruppe-III-Element basiert, wobei eine Oberfläche (23) des Trägers (14, 20, 22) erste Bereiche (20) eines ersten Materials aufweist, das den Wachstum der III-V-Verbindung fördert gemäß der Polarität des ersten Elements, das in einem zweiten Bereich (22) verteilt ist von einem zweiten Material, das den Wachstum der Verbindung fördert gemäß der Polarität des zweiten Elements, wobei die Mikroleitungen oder Nanoleitungen (24) auf den ersten Bereichen angeordnet sind, **dadurch gekennzeichnet, dass** die Peripherie des Teils (26) mit einer Schicht (36) aus dielektrischem Material bedeckt ist, und zwar von dem Träger bis zum Teil der Gesamthöhe des Teils, dass das dielektrische Material das erste Element und ein drittes Element aufweist, das unterschiedlich zu den ersten und zweiten Elementen ist, und dass in jede Mikroleitung oder Nanoleitung (24) ferner das dritte Element lediglich bis zu dem Teil der Gesamthöhe aufweist.

2. Optoelektrische Vorrichtung gemäß Anspruch 1, wobei die dielektrische Materialschicht (36) eine Dicke im Bereich zwischen einer atomaren Monolage und 5 nm hat.

3. Vorrichtung gemäß Anspruch 1 oder 2, wobei das erste Material Magnesiumnitrid oder Magnesium und Galliumnitrid aufweist.

4. Vorrichtung gemäß einem der Ansprüche 1 bis 3, wobei das zweite Material Aluminiumnitrid aufweist.

5. Vorrichtung gemäß einem der Ansprüche 1 bis 4, wobei Blöcke (32) an dem zweiten Bereich angeordnet sind, wobei die Blöcke die Verbindung aufweisen und eine Dicke im Bereich zwischen 50 nm und 5 µm haben und jedenfalls niedriger sind als die Höhe der Mikroleitungen oder Nanoleitungen (24).

6. Vorrichtung gemäß Anspruch 5, wobei die dielektrische Materialschicht (36) ferner die Blöcke (32) abdeckt.

7. Vorrichtung nach einem der Ansprüche 1 bis 6, wobei die ersten Bereiche (20) durch den zweiten Bereich (22) getrennt voneinander sind, und wobei für jeden ersten Bereich eine einzelne Mikroleitung oder Nanoleitung (24) in Kontakt mit dem ersten Bereich ist.

8. Vorrichtung nach einem der Ansprüche 1 bis 7, wobei die III-V-Verbindung eine III-N-Verbindung ist, und zwar vorzugsweise ausgewählt aus der Gruppe, die Galliumnitrid, Aluminiumnitrid, Indiumnitrid, Gallium und Indiumnitrid, Gallium und Aluminiumnitrid, und Gallium, Aluminium, und Indiumnitrid aufweist.

9. Vorrichtung nach einem der Ansprüche 1 bis 8, wobei das dielektrische Material Silikonnitrid aufweist.

10. Optoelektrische Vorrichtung gemäß einem der Ansprüche 1 bis 9, wobei die Gesamthöhe des Teils (26) jeder Mikroleitung oder Nanoleitung (24) größer oder gleich 500 nm ist.

11. Verfahren zur Herstellung der optoelektrischen Vorrichtung (10; 70) gemäß einem der Ansprüche 1 bis 10, wobei das Verfahren die folgenden Schritte aufweist:
(i) Ausbilden auf dem ersten Träger (14) der ersten Bereiche (20) des ersten Materials, das den Wachstum der III-V- Verbindung entsprechend der Polarität des ersten Elements fördert und des zweiten Bereichs (22) des zweiten Materials, das den Wachstum der Verbindung entsprechend der Polarität des zweiten Elements fördert, wobei die ersten Bereiche umgeben sind von dem zweiten Bereich; und
(ii) Ausbilden der Mikroleitungen oder Nanoleitungen (24) auf den ersten Bereichen durch simultanes Injizieren der Prekursoren der ersten und zweiten Elemente in einen Reaktor,
wobei das Verfahren das Ausbilden einer dielektrischen Materialschicht (36) aufweist, die den Teil (26) abdeckt, und zwar von dem Träger (14, 20, 22) bis zu Teilen der Höhe des Teils, das dielektrische Material das erste Element und auch ein drittes Element aufweist, das anders ist als die ersten und zweiten Elemente, und das Verfahren im Schritt (ii) das simultane Injizieren der Prekursoren der ersten, zweiten und dritten Elemente in den Reaktor aufweist.

12. Verfahren gemäß Anspruch 11, wobei der Schritt (ii) gefolgt ist von einem Schritt des Wachstums der Mikroleitungen oder Nanoleitungen (24) durch Injizieren der Prekursoren der ersten und zweiten Elemente in den Reaktor, ohne Injizieren des Prekursoren des dritten Elements.

13. Verfahren gemäß Anspruch 11 oder 12, das im Schritt (ii) ferner das Ausbilden von Blöcken (32) auf dem zweiten Bereich aufweist, wobei die Blöcke die Verbindung aufweisen und eine Dicke im Bereich zwischen 50 nm und 5 µm haben und jedenfalls niedriger sind als die Höhe der Mikroleitungen oder Nanoleitungen (24).

## Claims

1. An optoelectric device (10; 70) comprising microwires or nanowires (24) on a support (14, 20, 22), each microwire or nanowire comprising at least one portion (26) mainly containing a III-V compound in contact with the support, wherein the III-V compound is based on a first group-V element and on a second group-III element, wherein a surface (23) of the support (14, 20, 22) comprises first areas (20) of a first material promoting the growth of the III-V compound according to the polarity of the first element distributed in a second area (22) of a second material promoting the growth of the compound according to the polarity of the second element, the microwires or nanowires (24) being located on the first areas, **characterized in that** the periphery of said portion (26) is covered with a layer (36) of a dielectric material from the support up to part of the total height of said portion, **in that** the dielectric material comprises the first element and a third element, different from the first and second elements, and **in that** each microwire or nanowire (24) further comprises the third element up to said part of the total height only.

2. The optoelectric device of claim 1, wherein the dielectric material layer (36) has a thickness ranging between one atomic monolayer and 5 nm.

3. The device of claim 1 or 2, wherein the first material comprises magnesium nitride or magnesium and gallium nitride.

4. The device of any of claims 1 to 3, wherein the second material comprises aluminum nitride.

5. The device of any of claims 1 to 4, wherein blocks (32) are located on the second area, the blocks comprising said compound and having a thickness ranging between 50 nm and 5 µm and strictly smaller than the height of the microwires or nanowires (24).

6. The device of claim 5, wherein the dielectric material layer (36) further covers the blocks (32).

7. The device of any of claims 1 to 6, wherein the first areas (20) are separated from one another by the second area (22) and wherein, for each first area, a single microwire or nanowire (24) is in contact with said first area.

8. The device of any of claims 1 to 7, wherein the III-V compound is a III-N compound, especially selected from the group comprising gallium nitride, aluminum nitride, indium nitride, gallium and indium nitride, gallium and aluminum nitride, and gallium, aluminum, and indium nitride.

9. The device of any of claims 1 to 8, wherein the dielectric material comprises silicon nitride.

10. The optoelectric device of any of claims 1 to 9, wherein the total height of said portion (26) of each microwire or nanowire (24) is greater than or equal to 500 nm.

11. A method for manufacturing the optoelectric device (10; 70) of any of claims 1 to 10, the method comprising the steps of:
(i) forming, on the support (14), the first areas (20) of the first material promoting the growth of the III-V compound according to the polarity of the first element and the second area (22) of the second material promoting the growth of the compound according to the polarity of the second element, the first areas being surrounded by the second area; and
(ii) forming the microwires or nanowires (24) on the first areas by simultaneously injecting into a reactor the precursors of the first and second elements,
the method further comprising the forming of a dielectric material layer (36) covering said portion (26) from the support (14, 20, 22) up to part of the height of said portion, the dielectric material comprising the first element and also a third element different from the first and second elements, the method comprising, at step (ii), the simultaneous injection into the reactor of the precursors of the first, second, and third elements.

12. The method of claim 11, wherein step (ii) is followed by a step of growth of the microwires or nanowires (24) by injection into the reactor of the precursors of the first and second elements, without injecting the precursor of the third element.

13. The method of claim 11 or 12, further comprising, at step (ii), the forming of blocks (32) on the second area, the blocks comprising said compound and having a thickness ranging between 50 nm and 5 µm and strictly smaller than the height of the microwires or nanowires (24).
